# EUROPEAN PATENT SPECIFICATION

(11) **EP 1 647 027 B1**
(45) Date of publication and mention of the grant of the patent: **14.05.2008**
(21) Application number: 04756865.4
(22) Date of filing: 08.07.2004
(51) Int. Cl.: G11C 8/12

(54) **PROGRAMMABLE CHIP SELECT**
PROGRAMMIERBARES CHIPAUSWAHLSIGNAL
SELECTION DE PUCE PROGRAMMABLE

(30) Priority: 22.07.2003 US 625285
(43) Date of publication of application: 19.04.2006
(73) Proprietor: Intel Corporation, Santa Clara, CA 95052 (US)
(72) Inventor: MUNGUIA, Peter, Chandler, AZ 85248 (US); WANG,Eric, Mesa, AZ 85210 (US)
(74) Representative: Goddar, Heinz J.
(86) International application number: PCT/US2004/022184
(87) International publication number: WO 2005/010890

(56) References cited:
- US-A- 5 649 159
- US-A- 5 802 541
- US-A- 6 018 787

## Description

### BACKGROUND

A computing device may comprise firmware routines to initialize components of the computing device. Upon system startup, the computing device may activate a chip select of a non-volatile memory device having the firmware routines. The computing device may then retrieve and execute the firmware routines from the non-volatile memory device.
US Patent US 5,802,541 discloses a data processing system including a chip select circuit which allows flexible attribute protection. Each of two or more decoders determines whether a bus cycle address is within a programmable region and matches one or more programmable attributes, and if so, activates a corresponding match signal. A logical operation circuit then selectively causes a chip select signal to be activated in response to a logical operation performed on the match signals. The logical operation circuit may cause the chip select signal to be activated if either of two match signals is activated, allowing, for example, the same region of memory to be accessed from two address spaces using the same chip select signal. US 6018787 discloses a standard one-of-eight binary decoder that decodes a word of 3 coded chip select signals into eight additional chip select signals.
US 5649159 discloses a multi-level protection circuit which enables the generation of external control signals.

### BRIEF DESCRIPTION OF THE DRAWINGS

The invention described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements.
The invention is defined in independent claims 1, 16 and 23.

FIG. 1 illustrates an embodiment of a computing device without a chip select decoder.

FIG. 2 illustrates an embodiment of a computing device with a chip select decoder.

FIG. 3 illustrates a startup method that the computing devices of FIG. 1 and FIG. 2 may execute.

### DETAILED DESCRIPTION

The following description describes techniques for accessing non-volatile memory with encoded and unencoded chip select words. In the following description, numerous specific details such as logic implementations, opcodes, means to specify operands, resource partitioning/sharing/duplication implementations, types and interrelationships of system components, and logic partitioning/integration choices are set forth in order to provide a more thorough understanding of the present invention. It will be appreciated, however, by one skilled in the art that the invention may be practiced without such specific details. In other instances, control structures, gate level circuits and full software instruction sequences have not been shown in detail in order not to obscure the invention. Those of ordinary skill in the art, with the included descriptions, will be able to implement appropriate functionality without undue experimentation.

References in the specification to "one embodiment", "an embodiment", "an example embodiment", etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to effect such feature, structure, or characteristic in connection with other embodiments whether or not explicitly described.

Embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic disk storage media; optical storage media; flash memory devices; electrical, optical, acoustical or other forms of propagated signals (e.g., carrier waves, infrared signals, digital signals, etc.); and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc.

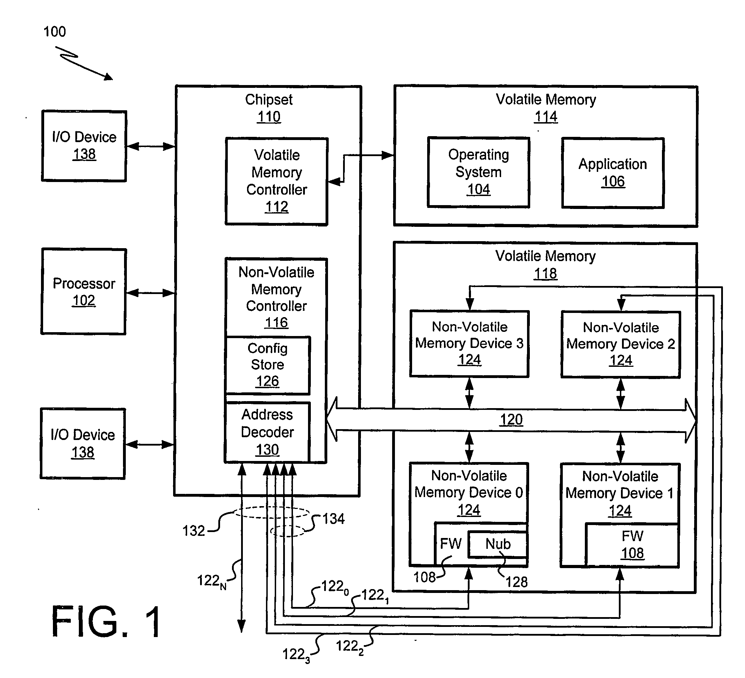

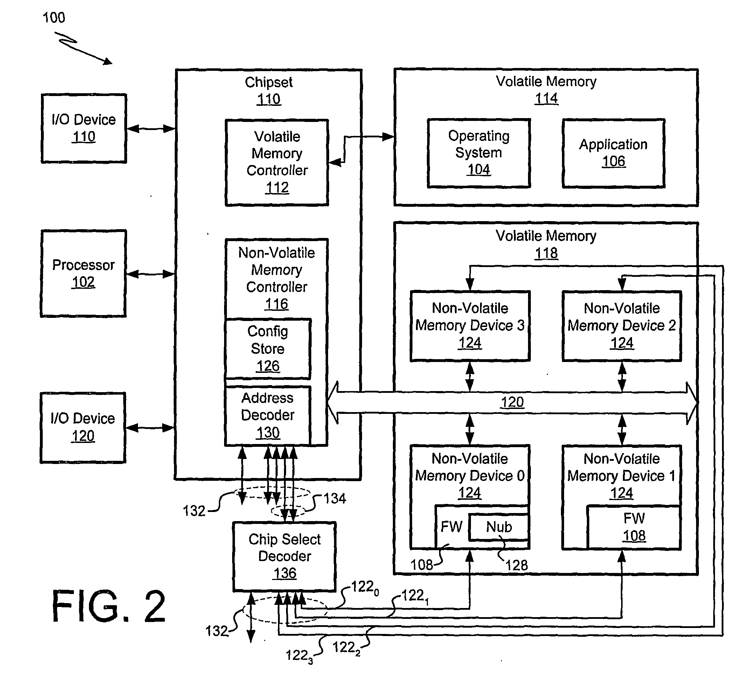

Example embodiments of a computing device 100 are shown in FIG. 1 and FIG. 2. As illustrated, the computing device 100 may comprise one or more processors 102. The processors 102 may perform actions in response to executing instructions of an operating system 104, application 106, basic input/output system (BIOS) firmware 108, and/or some other software or firmware module.

The computing device 100 may further comprise a chipset 110 that is coupled to the processors 102 via a processor bus. The chipset 110 may comprise one or more integrated circuit packages or chips that couple the processors 102 to other components of the computing device 100. In particular, the chipset 110 may comprise a volatile memory controller 112 that is coupled to volatile memory 114 via a memory bus. The chipset 110 may further comprise a non-volatile memory controller 116 that is coupled to a non-volatile memory 118 via an address/data bus 120, chip select lines 122₀, 122₁ ... 122_{N}, and/or other bus and control lines (not shown) such as, for example, row address strobes, column address strobes, write enables, etc.

Embodiments of the computing device 100 are illustrated in FIG. 1 and FIG. 2 with separate volatile and non-volatile memory controllers 112, 116. However, other embodiments may comprise a single memory controller to access both the volatile memory 114 and non-volatile memory 118. In yet another embodiment, the computing device 100 may be implemented without volatile memory 114 and a volatile memory controller 112.

The volatile memory 114 may comprise volatile memory devices (not shown) having addressable storage locations that may be read from and/or written to. The volatile memory devices may comprise one or more different volatile memory types such as, for example, RAM (Random Access Memory) devices, SRAM (Static RAM) devices, DRAM (Dynamic RAM Memory) devices, SDRAM (synchronous DRAM) devices, DDR (Double Data Rate) SDRAM devices, etc.. The non-volatile memory 118 may comprise non-volatile memory devices 124 having addressable storage locations that may be read from and/or written to. The non-volatile memory device 124 may comprise one or more different non-volatile memory types such as, for example, Flash memory devices, ROM (read only memory) devices, PROM (programmable read only memory) devices, EPROM (eraseable PROM) devices, EEPROM (electrically eraseable PROM) devices, Ferroelectric memory devices, battery-backed memory devices, etc.

The non-volatile memory controller 116 may comprise a programmable configuration store 126. The computing device 100 may update or program the configuration store 126 to define the operation of the non-volatile memory controller 116. In one embodiment, the configuration store 126 may configure the non-volatile memory controller 116 for an encoded chip select mode or an unencoded chip select mode. Moreover, the configuration store 126 may configure the non-volatile memory controller 116 for various non-volatile memory configurations. For example, the non-volatile memory controller 116 via the configuration store 126 may support multiple memory types, memory capacities, memory timings, etc.

In one embodiment, the configuration store 126 may default the non-volatile memory controller 116 to an encoded chip select mode. The configuration store 126 may further default the non-volatile memory controller to a memory configuration that assumes a non-volatile memory device 118 coupled to a predetermined chip select line 122 (e.g. chip select line 122₀), that the non-volatile memory device 118 consists of a minimum storage capacity (e.g. 1 megabyte) supported by the non-volatile memory device 124, that maps a boot code nub address to a boot code nub 128 stored in a predetermined non-volatile memory device 118, and that rolls over addresses to the predetermined non-volatile memory device 124 to ensure all addresses target the predetermined non-volatile memory device 124 until configured otherwise.

The non-volatile memory controller 116 may comprise an address decoder 130 to decode an address into a chip select word that selects a non-volatile memory device 124 to service a transaction, into a row address that selects the appropriate row of the selected non-volatile memory device 124, and a column address that selects the appropriate column of the selected row. In response to the unencoded chip select mode, the non-volatile memory controller 116 may generate an unencoded chip select word 132 (FIG. 1). The address decoder 130 may generate the unencoded chip select word 132 such that the unencoded chip select word 132 activates only a single chip select line 122 and deactivates the other chip select lines 122. In such an embodiment, the active chip select line 122 may select an associated non-volatile memory device 124 or a group of associated non-volatile memory devices 124 to service a transaction and the inactive chip select lines 122 may deselect the other non-volatile memory devices 124 of the non-volatile memory 118 that are not to service the transaction.

In response to the encoded chip select mode, the address decoder 130 may further generate an encoded chip select word 134 (FIG. 2) and provide the encoded chip select word 134 to a chip select decoder 136. The chip select decoder 136 may generate, from the received encoded chip select word 134, an unencoded chip select word 132 that activates only a single chip select line 122 and that deactivates the other chip select lines 122. In such an embodiment, the active chip select line 122 may select an associated non-volatile memory device 124 or a group of associated non-volatile memory devices 124 to service a transaction and the inactive chip select lines 122 may deselect the other non-volatile memory devices 124 of the non-volatile memory 118 that are not to service the transaction.

In an embodiment that supports up to eight non-volatile memory devices 124, the address decoder 130 may generate unencoded and encoded chip select words 132, 134 according to TABLE 1. Further, the chip select decoder 136 may generate the unencoded chip select words 134 in response to the receiving corresponding encoded chip select words 134 from the address decoder 130. In particular, the address decoder 130 and chip select decoder 136 may generate CS_Word_X to select the non-volatile memory device 124 coupled to the chip select line 122_{X}. Moreover, a binary 0 in TABLE 1 indicates an inactive bit of the chip select word and a binary 1 indicates an active bit of the chip select word. An active bit may correspond to a high signal and an inactive bit may correspond to a low signal. However, other signal encodings may be used such as, for example, representing an active bit with a low signal and an inactive bit with a high bit.

**TABLE 1**

| | **Encoded Chip Selects** | **Unencoded Chip Selects** |
|---|---|---|
| | **CS[2:0]** | **CS[7:0]** |
| CS_Word_0 | 001 b | 0000_0001b |
| CS_Word_2 | 010b | 0000_0010b |
| CS_Word_2 | 011b | 0000_0100b |
| CS_Word_3 | 100b | 0000_1000b |
| CS_Word_4 | 101b | 0001_0000b |
| CS_Word_5 | 110b | 0010_0000b |
| CS_Word_6 | 111 b | 0100_0000b |
| CS_Word_7 | 000b | 1000_0000b |

As illustrated in TABLE 1, the three lowest order bits [2:0] of the encoded chip select word CS_Word_0 and the three lowest order bits [2:0] of the unencoded chip select word CS_Word_0 are the same and include a single active bit. Assuming a valid platform, the address decoder 130 may select the non-volatile memory device 124 coupled to chip select line 122₀ by generating the unencoded chip select word CS_Word_0 or the encoded chip select word CS_Word_0. For example, if the computing device 100 does not include a chip select decoder 136 (See, FIG. 1), then the single active bit of the unencoded or encoded chip select word CS_Word_0 may activate the chip select line 122₀ and may select the corresponding non-volatile memory device 124. Similarly, if the computing device 100 includes a chip select decoder 136 (See, FIG. 2), then the chip select decoder 136 may generate the unencoded chip select word CS_Word_0 from a portion (e.g. the three lowest order bits CS[2:0]) of the unencoded chip select word CS_Word_0 or the encoded chip select word CS_Word_0 generated by the address decoder 130. The single active bit of the unencoded chip select word CS_Word_0 generated by the chip select decoder 136 may then activate the chip select line 122₀ and may select the corresponding non-volatile memory device 124.

In one embodiment, the BIOS firmware 108 may comprise routines which the computing device 100 may execute during system startup in order to initialize the processors 102, chipset 110, and other components of the computing device 100. Moreover, the BIOS firmware 108 may comprise routines or drivers which the computing device 100 may execute to communicate with one or more components of the computing device 100. In one embodiment, the BIOS firmware 108 may comprise routines to configure the non-volatile memory controller 116 and may comprise a boot code nub 128 to configure components of the computing device 100. In one embodiment, the boot code nub 128 may update the configuration store 126 to program whether the address decoder 130 generates encoded or unencoded chip select words 132, 134. The BIOS firmware 108 may further update the configuration store 126 to indicate which chip select lines 122₀, 122₁ ... 122_{N} are coupled to non-volatile memory devices 118 and to indicate the capacity of each non-volatile memory device 118.

As depicted in FIG. 1, the boot code nub 128 may reside in a non-volatile memory device 124 associated with a predetermined chip select line (e.g. chip select line 122₀). Moreover, the computing device 100 of FIG. 1 depicts that the BIOS firmware 108 may span more than one non-volatile memory device 124. In one such embodiment, the computing device 100 may executed the boot code nub 128 in order to configure the non-volatile memory controller 118 and enable access to the other non-volatile memory devices 124 and startup routines of the BIOS firmware 108 that reside in the other non-volatile memory devices 124. However, in other embodiments, the BIOS firmware 108 may reside in a single non-volatile memory device 124.

The chipset 110 may further comprise input/output (I/O) controllers (not shown) coupled to I/O devices 138 (e.g. a mouse, keyboard, video controller, network interface controller, hard disk, floppy disk, wireless receivers, wireless transmitters, etc.) via buses. For example, the chipset 110 may comprise peripheral component interconnect (PCI) controllers, accelerated graphics port (AGP) controllers, universal serial bus (USB) controllers, low pin count (LPC) bus controllers, and/or other input and/or output (I/O) controllers to control and transfer data via the respective buses.

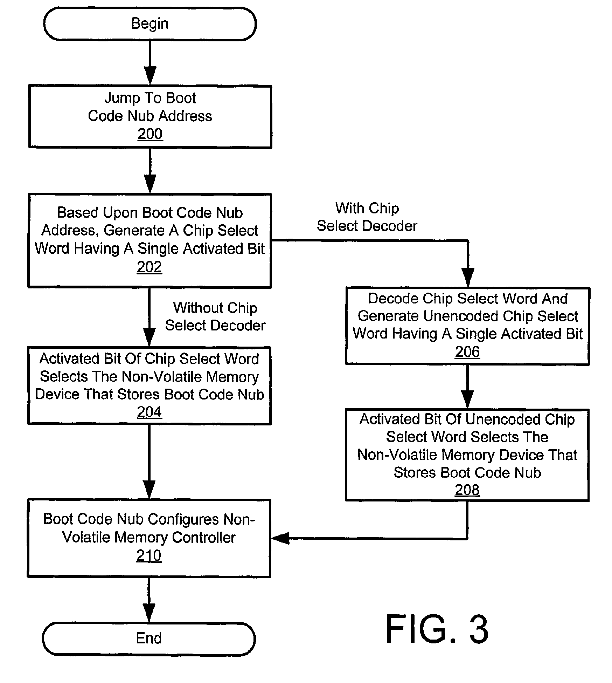

Referring now to FIG.3, there is shown a startup method that the computing device 100 of FIG. 1 or FIG. 2 may perform in response to a system power-up, a system reset, or some other event. The processor 102 in block 200 may jump to a boot code nub address (e.g. FFFF_FFFFh). The address decoder 130 may decode the boot code nub address and generate a chip select word 132, 134 (e.g. unencoded or encoded chip select word CS_Word_0) having a single active bit to select the predetermined non-volatile memory device 124 that comprises the boot code nub 128 in block 202. The address decoder 130 may further generate a row address and column address which the non-volatile memory controller 116 may use to retrieve the portion of the boot code nub 128 stored at the boot code nub address.

If the computing device 100 does not have a chip select decoder 136, then the active bit of the encoded or unencoded chip select word 132, 134 generated by address decoder 130 may select the predetermined non-volatile memory device 124 that comprises the boot code nub 128 in block 204. However, if the computing device 100 comprises the chip select decoder 136, then the chip select decoder 136 in block 206 may decode the encoded or unencoded chip select word 132, 134 of the address decoder 130 and may generate an unencoded chip select word (e.g. unencoded chip select word CS_Word_0) having a single active bit to select the predetermined non-volatile memory device 124 that comprises the boot code nub 128. The active bit of the unencoded chip select word generated by chip select decoder 136 may select in block 208 the predetermined non-volatile memory device 124 that comprises the boot code nub 128.

The processor 102 in block 210 may retrieve and execute the boot code nub 128 from the selected non-volatile memory device 124. In one embodiment, the processor 102 may configure components of the computing device 100 such as, for example, the non-volatile memory controller 124 in response to executing the boot code nub 128. In particular, the processor 102 may update the configuration store 126 for an encoded chip select mode if the processor 102 determines that the computing device 100 comprises the chip select decoder 136. Alternatively, the processor 102 may update the configuration store 126 for an unencoded chip select mode if the processor 102 determines that the computing device 100 does not include a chip select decoder.

Moreover, processor 102 may update the configuration store 126 to configure the non-volatile memory controller 116 for the types and capacities of the non-volatile memory devices 124 detected by the processor 102 in response to executing the boot code nub 128. The processor 102 may further update the configuration store 126 to disable rolling addresses over to the predetermined non-volatile memory device 124 that comprises the boot code nub 128. After configuring the non-volatile memory controller 116, the processor 102 in response to executing the boot code nub 128 or the BIOS firmware 108 may reassign unused chip select pins for other purposes, such as, a General Purpose Event (GPE).

While certain features of the invention have been described with reference to example embodiments, the description is not intended to be construed in a limiting sense. Various modifications of the example embodiments, as well as other embodiments of the invention, which are apparent to persons skilled in the art to which the invention pertains are deemed to lie within the scope of the invention.

## Claims

1. A system comprising
a plurality of memory devices (124) comprising a memory device with a boot code nub (128), **characterized by**
an apparatus
to generate, in response to a system power up or a system reset and in response to an address of a boot code nub and an encoded chip select mode, an encoded chip select word that selects the memory device with the boot code nub, and
to generate, in response to a system power up or a system reset and in response to the address of the boot code nub and an unencoded chip select mode, an unencoded chip select word that comprises the encoded chip select word of the boot code nub and that selects the memory device with the boot code nub.

2. The system of claim 1 wherein
the memory device with the boot code nub is coupled to the apparatus via a predetermined chip select line (122), and
each of the other memory devices of the plurality of memory devices is coupled to the apparatus via a separate chip select line (122).

3. The system of claim 1 further comprising a chip select decoder (123) coupled to the apparatus and coupled to each of the memory devices (124) of the plurality of memory devices via a separate chip select line (134), wherein
the chip select decoder activates the chip select line of the memory device with the boot code nub in response to receiving the encoded chip select word for the address from the apparatus.

4. The system of claim 3 wherein the chip select decoder activates the chip select line of the memory device with the boot code nub in response to receiving the unencoded chip select word for the address from the apparatus.

5. The system of claim 1 further comprising a chip select decoder coupled to the apparatus and coupled to each of the memory devices of the plurality of memory devices via a separate chip select line, wherein
the chip select decoder activates the chip select line of the memory device with the boot code nub in response to receiving the encoded chip select word for the address of the boot code nub from the unencoded chip select word generated by the apparatus for the address of the boot code nub.

6. The system of one of the preceding claims comprising
means for updating an operation mode to one of the encoded chip select mode and the unencoded chip select mode.

7. The system of one of the claims 1 to 5 comprising
means for executing the boot code nub, and
means for updating an operation mode to one of the encoded chip select mode and the unencoded chip select mode in response to executing the boot code nub.

8. The system of one of the claims 1 to 5 comprising
means for executing the boot code nub,
means for updating an operation mode to the encoded chip select mode in response to executing the bood code nub, and
means for reassigning chip select pins not used to carry encoded chip select words after updating the operation mode.

9. The system of one of the preceding claims, wherein the apparatus comprises
a configuration store (126) to select between an encoded chip select mode and an unencoded chip select mode, and
an address decoder (130) to generate unencoded chip select words in response to the unencoded chip select mode and to generate encoded chip select words in response to the the encoded chip select mode.

10. The system of claim 9 wherein the address decoder in response to an address for a boot code nub (128) generates a chip select word that selects the same memory device regardless of operating in the unencoded chip select mode or the encoded chip select mode.

11. The system of claim 9 wherein the address decoder in response to an address for a boot code nub
generates an encoded chip select word that selects a predetermined memory device (124) that comprises the boot code nub (128) when in the encoded chip select mode, and
generates an unencoded chip select that selects the predetermined memory device that comprises the boot code nub when in the unencoded chip select mode.

12. The system of claim 9 wherein the address decoder, in response to an address for a boot code nub, generates the unencoded chip select word for the address such that the unencoded chip select word comprises the encoded chip select word for the address.

13. The system of claim 9 wherein the address decoder, in response to an address for a boot code nub,
generates the encoded chip select word for the address such that the encoded chip select word comprises exactly one active chip select bit, and
generates the unencoded chip select word for the address such that the unencoded chip select word comprises exactly one active chip select bit.

14. The system of claim 9 wherein the address decoder, in response to an address for a boot code nub,
generates the encoded chip select word for the address such that the encoded chip select word comprises exactly one active chip select bit that corresponds to a predetermined chip select line used to select a memory device comprising the boot code nub, and
generates the unencoded chip select word for the address such that the unencoded chip select word comprises exactly one active chip select bit that corresponds to the predetermined chip select line.

15. The apparatus of claim 9 wherein the address decoder, in response to an address for a boot code nub,
generates the encoded chip select word such that a lowest order bit of the encoded chip select word is the only active bit of the encoded chip select word, and
generates the unencoded chip select word such that a lowest order bit of the unencoded chip select word is the only active bit of the unencoded chip select word.

16. A method **characterized in that** it comprises
in response to a system power-up or system reset
generating, in response to an address of a boot code nub and an encoded chip select mode, an encoded chip select word that selects a memory device with the boot code nub, and
generating (206), in response to the address of the boot code nub and an unencoded chip select mode, an unencoded chip select word that comprises the encoded chip select word of the boot code nub for selecting the same memory device regardless of operating in the unencoded chip select mode or the encoded chip select mode.

17. The method of claim 16 further comprising
updating an operation mode to one of the encoded chip select mode and the unencoded chip select mode.

18. The method of claim 16 further comprising
executing the boot code nub, and
updating an operation mode to one of the encoded chip select mode and the unencoded chip select mode in response to executing the boot code nub.

19. The method of claim 16 further comprising
executing the boot code nub,
updating an operation mode to the encoded chip select mode in response to executing the bood code nub, and
reassigning chip select pins not used to carry encoded chip select words after updating the operation mode.

20. The method of claim 16 wherein
generating the encoded chip select word comprises generating the encoded chip select word such that the encoded chip select word comprises exactly one active chip select bit, and
generating the unencoded chip select word comprises generating the unencoded chip select word such that the unencoded chip select word comprises exactly one active chip select bit.

21. The method of claim 16 wherein
generating the encoded chip select word comprises generating the encoded chip select word such that the encoded chip select word comprises exactly one active chip select bit that corresponds to a predetermined chip select line used to select the memory device with the boot code nub, and
generating the unencoded chip select word comprises generating the unencoded chip select word such that the unencoded chip select word comprises exactly one active chip select bit that corresponds to the predetermined chip select line.

22. The method of claim 16 wherein
generating the encoded chip select word comprises generating the encoded chip select word such that a lowest order bit of the encoded chip select word is the only active bit of the encoded chip select word, and
generating the unencoded chip select word comprises generating the unencoded chip select word such that a lowest order bit of the unencoded chip select word is the only active bit of the unencoded chip select word.

23. A machine readable medium comprising a plurality of instructions that, in response to being executed result, in an apparatus
in response to a system power-up or system reset
in generating, in response to an address of a boot code nub and an encoded chip select mode, an encoded chip select word that selects a memory device with the boot code nub, and
generating, in response to the address of the boot code nub and an unencoded chip select mode, an unencoded chip select word that comprises the encoded chip select word of the boot code nub for selecting the same memory device regardless of operating in the unencoded chip select mode or the encoded chip select mode.

24. The machine readable medium of claim 23 wherein the plurality of instructions further result in the apparatus
generating the encoded chip select word such that the encoded chip select word comprises exactly one active chip select bit, and
generating the unencoded chip select word such that the unencoded chip select word comprises exactly one active chip select bit.

25. The machine readable medium of claim 23 wherein the plurality of instructions further result in the apparatus
generating the encoded chip select word such that the encoded chip select word comprises exactly one active chip select bit that corresponds to a predetermined chip select line used to select the memory device with the boot code nub, and
generating the unencoded chip select word such that the unencoded chip select word comprises exactly one active chip select bit that corresponds to the predetermined chip select line.

26. The machine readable medium of claim 23 wherein the plurality of instructions further result in the apparatus
generating the encoded chip select word such that a lowest order bit of the encoded chip select word is the only active bit of the encoded chip select word, and
generating the unencoded chip select word such that a lowest order bit of the unencoded chip select word is the only active bit of the unencoded chip select word.

27. The machine readable medium of claim 23, wherein the plurality of instructions further results in the apparatus
updating an operation mode to one of the encoded chip select mode and the unencoded chip select mode.

28. The machine readable medium of claim 23, wherein the plurality of instructions further results in the apparatus
executing the boot code nub, and
updating an operation mode to one of the encoded chip select mode and the unencoded chip select mode in response to executing the boot code nub,

29. The machine readable medium of claim 23, wherein the plurality of instructions further results in the apparatus
executing the boot code nub,
updating an operation mode to the encoded chip select mode in response to executing the bood code nub, and
reassigning chip select pins not used to carry encoded chip select words after updating the operation mode.

## Patentansprüche

1. System, umfassend
mehrere Speichervorrichtungen (124), die eine Speichervorrichtung mit einem Bootcode-Kernpunkt (128) umfassen, **gekennzeichnet durch**
eine Vorrichtung
zum Generieren, in Antwort auf einen Systemstart oder eine Systemrückstellung und in Antwort auf eine Adresse eines Bootcode-Kernpunkts und eines codierten Chipauswahlmodus, eines codierten Chipauswahlwortes, das die Speichervorrichtung mit dem Bootcode-Kernpunkt auswählt, und
zum Generieren, in Antwort auf einen Systemstart oder eine Systemrückstellung und in Antwort auf die Adresse des Bootcode-Kernpunkts und eines nicht codierten Chipauswahlmodus, eines nicht codierten Chipauswahlwortes, welches das codierte Chipauswahlwort des Bootcode-Kernpunkts umfaßt und die Speichervorrichtung mit dem Bootcode-Kernpunkt auswählt.

2. System nach Anspruch 1, wobei
die Speichervorrichtung mit dem Bootcode-Kernpunkt mit der Vorrichtung über eine vorgegebene Chipauswahlleitung (122) verbunden ist, und
jede der anderen Speichervorrichtungen der mehreren Speichervorrichtungen mit der Vorrichtung über eine getrennte Chipauswahlleitung (122) verbunden ist.

3. System nach Anspruch 1, ferner umfassend einen Chipauswahldecoder (123), der mit der Vorrichtung verbunden ist und mit jeder der Speichervorrichtungen (124) der mehreren Speichervorrichtungen über eine getrennte Chipauswahlleitung (134) verbunden ist, wobei
der Chipauswahldecoder die Chipauswahlleitung der Speichervorrichtung mit dem Bootcode-Kernpunkt in Antwort auf den Empfang des codierten Chipauswahlwortes für die Adresse von der Vorrichtung aktiviert.

4. System nach Anspruch 3, wobei der Chipauswahldecoder die Chipauswahlleitung der Speichervorrichtung mit dem Bootcode-Kernpunkt in Antwort auf den Empfang des nicht codierten Chipauswahlwortes für die Adresse von der Vorrichtung aktiviert.

5. System nach Anspruch 1, ferner umfassend einen Chipauswahldecoder, der mit der Vorrichtung verbunden ist und mit jeder der Speichervorrichtungen der mehreren Speichervorrichtungen über eine getrennte Chipauswahlleitung verbunden ist, wobei
der Chipauswahldecoder die Chipauswahlleitung der Speichervorrichtung mit dem Bootcode-Kernpunkt in Antwort auf den Empfang des codierten Chipauswahlwortes für die Adresse des Bootcode-Kernpunktes von dem nicht codierten Chipauswahlwort, das von der Vorrichtung für die Adresse des Bootcode-Kernpunktes generiert wird, aktiviert.

6. System nach einem der vorhergehenden Ansprüche, umfassend
Mittel zum Aktualisieren eines Betriebsmodus auf einen des codierten Chipauswahlmodus und des nicht codierten Chipauswahlmodus.

7. System nach einem der Ansprüche 1 bis 5, umfassend
Mittel zum Ausführen des Bootcode-Kernpunktes, und
Mittel zum Aktualisieren eines Betriebsmodus auf einen des codierten Chipauswahlmodus und des nicht codierten Chipauswahlmodus in Antwort auf die Ausführung des Bootcode-Kernpunktes.

8. System nach einem der Ansprüche 1 bis 5, umfassend
Mittel zum Ausführen des Bootcode-Kernpunktes,
Mittel zum Aktualisieren des Betriebsmodus auf den codierten Chipauswahlmodus in Antwort auf die Ausführung des Bootcode-Kernpunktes, und
Mittel zum Neuzuweisen von nicht benutzten Chipauswahl-Anschlußstiften, um die codierten Chipauswahlwörter nach Aktualisieren des Betriebsmodus zu tragen.

9. System nach einem der vorhergehenden Ansprüche, wobei die Vorrichtung folgendes umfaßt
einen Konfigurationsspeicher (126), um zwischen einem codierten Chipauswahlmodus und einem nicht codierten Chipauswahlmodus zu wählen, und
einen Adreßdecoder (130), um nicht codierte Chipauswahlwörter in Antwort auf den nicht codierten Chipauswahlmodus zu generieren und codierte Chipauswahlwörter in Antwort auf den codierten Chipauswahlmodus zu generieren.

10. System nach Anspruch 9, wobei der Adreßdecoder in Antwort auf eine Adresse für einen Bootcode-Kernpunkt (128) ein Chipauswahlwort generiert, das ungeachtet des Betriebs in dem nicht codierten Chipauswahlmodus oder dem codierten Chipauswahlmodus die gleiche Speichervorrichtung auswählt.

11. System nach Anspruch 9, wobei der Adreßdecoder in Antwort auf eine Adresse für einen Bootcode-Kernpunkt
im codierten Chipauswahlmodus ein codiertes Chipauswahlwort generiert, das eine vorgegebene Speichervorrichtung (124) auswählt, die den Bootcode-Kernpunkt (128) umfaßt, und
im nicht codierten Chipauswahlmodus ein nicht codiertes Chipauswahlwort generiert, das die vorgegebene Speichervorrichtung auswählt, die den Bootcode-Kernpunkt umfaßt.

12. System nach Anspruch 9, wobei der Adreßdecoder in Antwort auf eine Adresse für einen Bootcode-Kernpunkt das nicht codierte Chipauswahlwort für die Adresse derart generiert, daß das nicht codierte Chipauswahlwort das codierte Chipauswahlwort für die Adresse umfaßt.

13. System nach Anspruch 9, wobei der Adreßdecoder in Antwort auf eine Adresse für einen Bootcode-Kernpunkt
das codierte Chipauswahlwort für die Adresse derart generiert, daß das codierte Chipauswahlwort ein exakt aktives Chipauswahlbit umfaßt, und
das nicht codierte Chipauswahlwort für die Adresse derart generiert, daß das nicht codierte Chipauswahlwort exakt ein aktives Chipauswahlbit umfaßt.

14. System nach Anspruch 9, wobei der Adreßdecoder in Antwort auf eine Adresse für einen Bootcode-Kernpunkt
das codierte Chipauswahlwort für die Adresse derart generiert, daß das codierte Chipauswahlwort exakt ein aktives Chipauswahlbit umfaßt, das einer vorgegebenen Chipauswahlleitung entspricht, die benutzt wird, um eine Speichervorrichtung auszuwählen, die den Bootcode-Kernpunkt umfaßt, und
das nicht codierte Chipauswahlwort für die Adresse derart generiert, daß das nicht codierte Chipauswahlwort exakt ein aktives Chipauswahlbit umfaßt, das der vorgegebenen Chipauswahlleitung entspricht.

15. Vorrichtung nach Anspruch 9, wobei der Adreßdecoder in Antwort auf eine Adresse für einen Bootcode-Kernpunkt
das codierte Chipauswahlwort derart generiert, daß ein Bit der niedrigsten Ordnung des codierten Chipauswahlwortes das einzige aktive Bit des codierten Chipauswahlwortes ist, und
das nicht codierte Chipauswahlwort derart generiert, daß ein Bit der niedrigsten Ordnung des nicht codierten Chipauswahlwortes das einzige aktive Bit des nicht codierten Chipauswahlwortes ist.

16. Verfahren, **dadurch gekennzeichnet, daß**
es in Antwort auf einen Systemstart oder eine Systemrückstellung folgendes umfaßt
Generieren, in Antwort auf eine Adresse eines Bootcode-Kernpunktes und eines codierten Chipauswahlmodus, eines codierten Chipauswahlwortes, das eine Speichervorrichtung mit dem Bootcode-Kernpunkt auswählt, und
Generieren (206), in Antwort auf die Adresse des Bootcode-Kernpunktes und eines nicht codierten Chipauswahlmodus, eines nicht codierten Chipauswahlwortes, welches das codierte Chipauswahlwort des Bootcode-Kernpunktes umfaßt, um ungeachtet des Betriebs in dem nicht codierten Chipauswahlmodus oder dem codierten Chipauswahlmodus die gleiche Speichervorrichtung auszuwählen.

17. Verfahren nach Anspruch 16, ferner umfassend
Aktualisieren eines Betriebsmodus auf einen des codierten Chipauswahlmodus und des nicht codierten Chipauswahlmodus.

18. Verfahren nach Anspruch 16, ferner umfassend
Ausführen des Bootcode-Kernpunktes, und
Aktualisieren eines Betriebsmodus auf einen des codierten Chipauswahlmodus und des nicht codierten Chipauswahlmodus in Antwort auf die Ausführung des Bootcode-Kernpunktes.

19. Verfahren nach Anspruch 16, ferner umfassend
Ausführen des Bootcode-Kernpunktes,
Aktualisieren eines Betriebsmodus auf den codierten Chipauswahlmodus in Antwort auf die Ausführung des Bootcode-Kernpunktes, und
Neuzuweisen von nicht benutzten Chipauswahl-Anschlußstiften, um codierte Chipauswahlwörter nach Aktualisieren des Betriebsmodus zu tragen.

20. Verfahren nach Anspruch 16, wobei
das Generieren des codierten Chipauswahlwortes ein derartiges Generieren des codierten Chipauswahlwortes umfaßt, daß das codierte Chipauswahlwort exakt ein aktives Chipauswahlbit umfaßt, und
das Generieren des nicht codierten Chipauswahlwortes ein derartige Generieren des nicht codierten Chipauswahlwortes umfaßt, daß das nicht codierte Chipauswahlwort exakt ein aktives Chipauswahlbit umfaßt.

21. Verfahren nach Anspruch 16, wobei
das Generieren des codierten Chipauswahlwortes ein derartiges Generieren des codierten Chipauswahlwortes umfaßt, daß das codierte Chipauswahlwort exakt ein aktives Chipauswahlbit umfaßt, das einer vorgegebenen Chipauswahlleitung entspricht, die benutzt wird, um die Speichervorrichtung mit dem Bootcode-Kempunkt auszuwählen, und
das Generieren des nicht codierten Chipauswahlwortes ein derartige Generieren des nicht codierten Chipauswahlwortes umfaßt, daß das nicht codierte Chipauswahlwort exakt ein aktives Chipauswahlbit umfaßt, das der vorgegebenen Chipauswahlleitung entspricht.

22. Verfahren nach Anspruch 16, wobei
das Generieren des codierten Chipauswahlwortes ein derartiges Generieren des codierten Chipauswahlwortes umfaßt, daß ein Bit der niedrigsten Ordnung des codierten Chipauswahlwortes das einzige aktive Bit des codierten Chipauswahlwortes ist, und
das Generieren des nicht codierten Chipauswahlwortes ein derartiges Generieren des nicht codierten Chipauswahlwortes umfaßt, daß ein Bit der niedrigsten Ordnung des nicht codierten Chipauswahlwortes das einzige aktive Bit des nicht codierten Chipauswahlwortes ist.

23. Maschinenlesbares Medium, umfassend mehrere Befehle, die in Antwort auf ihre Ausführung bewirken, daß eine Vorrichtung
in Antwort auf einen Systemstart oder eine Systemrückstellung
in Antwort auf eine Adresse eines Bootcode-Kempunktes und eines codierten Chipauswahlmodus, ein codiertes Chipauswahlwort generiert, das eine Speichervorrichtung mit dem Bootcode-Kempunkt auswählt, und
in Antwort auf die Adresse des Bootcode-Kempunktes und eines nicht codierten Chipauswahlmodus, ein nicht codiertes Chipauswahlwort, welches das codierte Chipauswahlwort des Bootcode-Kernpunktes umfaßt, generiert, um ungeachtet des Betriebs in dem nicht codierten Chipauswahlmodus oder dem codierten Chipauswahlmodus die gleiche Speichervorrichtung auszuwählen.

24. Maschinenlesbares Medium nach Anspruch 23, wobei die mehreren Befehle ferner dazu führen, daß die Vorrichtung
das codierte Chipauswahlwort für die Adresse derart generiert, daß das codierte Chipauswahlwort exakt ein aktives Chipauswahlbit umfaßt, und
das nicht codierte Chipauswahlwort derart generiert, daß das nicht codierte Chipauswahlwort exakt ein aktives Chipauswahlbit umfaßt.

25. Maschinenlesbares Medium nach Anspruch 23, wobei die mehreren Befehle ferner dazu führen, daß die Vorrichtung
das codierte Chipauswahlwort derart generiert, daß das codierte Chipauswahlwort exakt ein aktives Chipauswahlbit umfaßt, das einer vorgegebenen Chipauswahlleitung entspricht, die benutzt wird, um eine Speichervorrichtung mit dem Bootcode-Kernpunkt auszuwählen, und
das nicht codierte Chipauswahlwort derart generiert, daß das nicht codierte Chipauswahlwort exakt ein aktives Chipauswahlbit umfaßt, das der vorgegebenen Chipauswahlleitung entspricht.

26. Maschinenlesbares Medium nach Anspruch 23, wobei die mehreren Befehle ferner dazu führen, daß die Vorrichtung
das codierte Chipauswahlwort derart generiert, daß ein Bit der niedrigsten Ordnung des codierten Chipauswahlwortes das einzige aktive Bit des codierten Chipauswahlwortes ist, und
das nicht codierte Chipauswahlwort derart generiert, daß ein Bit der niedrigsten Ordnung des nicht codierten Chipauswahlwortes das einzige aktive Bit des nicht codierten Chipauswahlwortes ist.

27. Maschinenlesbares Medium nach Anspruch 23, wobei die mehreren Befehle ferner dazu führen, daß die Vorrichtung
einen Betriebsmodus auf einen des codierten Chipauswahlmodus und des nicht codierten Chipauswahlmodus aktualisiert.

28. Maschinenlesbares Medium nach Anspruch 23, wobei die mehreren Befehle ferner dazu führen, daß die Vorrichtung
den Bootcode-Kernpunkt ausführt, und
einen Betriebsmodus auf einen des codierten Chipauswahlmodus und des nicht codierten Chipauswahlmodus in Antwort auf die Ausführung des Bootcode-Kernpunktes aktualisiert.

29. Maschinenlesbares Medium nach Anspruch 23, wobei die mehreren Befehle ferner dazu führen, daß die Vorrichtung
den Bootcode-Kernpunkt ausführt,
einen Betriebsmodus auf den codierten Chipauswahlmodus in Antwort auf die Ausführung des Bootcode-Kernpunktes aktualisiert, und
nicht benutzte Chipauswahl-Anschlußstifte neu zuweist, um codierte Chipauswahlwörter nach Aktualisieren des Betriebsmodus zu tragen.

## Revendications

1. Système comprenant
une pluralité de dispositifs de mémoire (124) comprenant un dispositif de mémoire avec un nub de code d'amorçage (128), **caractérisé par**
un appareil
pour générer, en réponse à une mise sous tension du système ou une réinitialisation du système et en réponse à une adresse d'un nub de code d'amorçage et un mode de sélection de puce codée, un mot de sélection de puce codée qui sélectionne le dispositif de mémoire avec le nub de code d'amorçage, et
pour générer, en réponse à une mise sous tension du système ou une réinitialisation du système et en réponse à l'adresse du nub de code d'amorçage et un mode de sélection de puce non codée, un mot de sélection de puce non codée qui comprend le mot de sélection de puce non codée du nub de code d'amorçage et qui sélectionne le dispositif de mémoire avec le nub de code d'amorçage.

2. Système selon la revendication 1, dans lequel
le dispositif de mémoire avec le nub de code d'amorçage est couplé à l'appareil par le biais d'une ligne de sélection de puce prédéterminée (122), et
chacun des autres dispositifs de mémoire de la pluralité de dispositifs de mémoire est couplé à l'appareil par le biais d'une ligne de sélection de puce séparée (122).

3. Système selon la revendication 1, comprenant en outre un décodeur de sélection de puce (123) couplé à l'appareil et couplé à chacun des dispositifs de mémoire (124) de la pluralité de dispositifs de mémoire par le biais d'une ligne de sélection de puce séparée (134), dans lequel
le décodeur de sélection de puce active la ligne de sélection de puce du dispositif de mémoire avec le nub de code d'amorçage en réponse à la réception du mot de sélection de puce codée pour l'adresse de l'appareil.

4. Système selon la revendication 3, dans lequel le décodeur de sélection de puce active la ligne de sélection de puce du dispositif de mémoire avec le nub de code d'amorçage en réponse à la réception du mot de sélection de puce non codée pour l'adresse de l'appareil.

5. Système selon la revendication 1, comprenant en outre un décodeur de sélection de puce couplé à l'appareil et couplé à chacun des dispositifs de mémoire de la pluralité de dispositifs de mémoire par le biais d'une ligne de sélection de puce séparée, dans lequel
le décodeur de sélection de puce active la ligne de sélection de puce du dispositif de mémoire avec le nub de code d'amorçage en réponse à la réception du mot de sélection de puce codée pour l'adresse du nub de code d'amorçage du mot de sélection de puce non codée généré par l'appareil pour l'adresse du nub de code d'amorçage.

6. Système selon l'une des revendications précédentes, comprenant
un moyen pour mettre à jour un mode de fonctionnement en l'un du mode de sélection de puce codée et du mode de sélection de puce non codée.

7. Système selon l'une des revendications 1 à 5, comprenant
un moyen pour exécuter le nub de code d'amorçage, et
un moyen pour mettre à jour un mode de fonctionnement en l'un du mode de sélection de puce codée et du mode de sélection de puce non codée en réponse à l'exécution du nub de code d'amorçage.

8. Système selon l'une des revendications 1 à 5, comprenant
un moyen pour exécuter le nub de code d'amorçage,
un moyen pour mettre à jour un mode de fonctionnement en le mode de sélection de puce codée en réponse à l'exécution du nub de code d'amorçage, et
un moyen pour réattribuer des broches de sélection de puce non utilisées pour porter des mots de sélection de puce codée après la mise à jour du mode de fonctionnement.

9. Système selon l'une des revendications précédentes, dans lequel l'appareil comprend
un espace de stockage de configuration (126) pour choisir entre un mode de sélection de puce codée et un mode de sélection de puce non codée, et
un décodeur d'adresse (130) pour générer des mots de sélection de puce non codée en réponse au mode de sélection de puce non codée et pour générer des mots de sélection de puce codée en réponse au mode de sélection de puce codée.

10. Système selon la revendication 9, dans lequel le décodeur d'adresse en réponse à une adresse pour un nub de code d'amorçage (128) génère un mot de sélection de puce qui sélectionne le même dispositif de mémoire, peu importe si le mode de fonctionnement est en mode de sélection de puce non codée ou en mode de sélection de puce codée.

11. Système selon la revendication 9, dans lequel le décodeur d'adresse en réponse à une adresse pour un nub de code d'amorçage
génère un mot de sélection de puce codée qui sélectionne un dispositif de mémoire prédéterminé (124) qui comprend le nub de code d'amorçage (128) en mode de sélection de puce codée, et
génère un mot de sélection de puce non codée qui sélectionne le dispositif de mémoire prédéterminé qui comprend le nub de code d'amorçage en mode de sélection de puce non codée.

12. Système selon la revendication 9, dans lequel le décodeur d'adresse, en réponse à une adresse pour un nub de code d'amorçage, génère le mot de sélection de puce non codée pour l'adresse de sorte que le mot de sélection de puce non codée comprend le mot de sélection de puce codée pour l'adresse.

13. système selon la revendication 9, dans lequel le décodeur d'adresse, en réponse à une adresse pour un nub de code d'amorçage,
génère le mot de sélection de puce codée pour l'adresse de sorte que le mot de sélection de puce codée comprend exactement un bit de sélection de puce actif, et
génère le mot de sélection de puce non codée pour l'adresse de sorte que le mot de sélection de puce non codée comprend exactement un bit de sélection de puce actif.

14. Système selon la revendication 9, dans lequel le décodeur d'adresse, en réponse à une adresse pour un nub de code d'amorçage,
génère le mot de sélection de puce codée pour l'adresse de sorte que le mot de sélection de puce codée comprend exactement un bit de sélection de puce actif qui correspond à une ligne de sélection de puce prédéterminée utilisée pour sélectionner un dispositif de mémoire comprenant le nub de code d'amorçage, et
génère le mot de sélection de puce non codée pour l'adresse de sorte que le mot de sélection de puce non codée comprend exactement un bit de sélection de puce actif qui correspond à la ligne de sélection de puce prédéterminée.

15. Appareil selon la revendication 9, dans lequel le décodeur d'adresse, en réponse à une adresse pour un nub de code d'amorçage,
génère le mot de sélection de puce codée de sorte qu'un bit d'ordre inférieur du mot de sélection de puce codée est le seul bit actif du mot de sélection de puce codée, et
génère le mot de sélection de puce non codée de sorte qu'un bit d'ordre inférieur du mot de sélection de puce non codée est le seul bit actif du mot de sélection de puce non codée.

16. Procédé **caractérisé en ce qu'**il comprend les étapes consistant à
en réponse à une mise sous tension du système ou une réinitialisation du système
générer, en réponse à une adresse d'un nub de code d'amorçage et un mode de sélection de puce codée, un mot de sélection de puce codée qui sélectionne un dispositif de mémoire avec le nub de code d'amorçage, et
générer (206), en réponse à l'adresse du nub de code d'amorçage et un mode de sélection de puce non codée, un mot de sélection de puce non codée qui comprend le mot de sélection de puce codée du nub de code d'amorçage pour sélectionner le même dispositif de mémoire, peu importe si le mode de fonctionnement est en mode de sélection de puce non codée ou en mode de sélection de puce codée.

17. Procédé selon la revendication 16, comprenant en outre l'étape consistant à
mettre à jour un mode de fonctionnement en l'un du mode de sélection de puce codée et du mode de sélection de puce non codée.

18. Procédé selon la revendication 16, comprenant en outre les étapes consistant à
exécuter le nub de code d'amorçage, et
mettre à jour un mode de fonctionnement en l'un du mode de sélection de puce codée et du mode de sélection de puce non codée en réponse à l'exécution du nub de code d'amorçage.

19. Procédé selon la revendication 16, comprenant en outre les étapes consistant à
exécuter le nub de code d'amorçage,
mettre à jour un mode de fonctionnement en le mode de sélection de puce codée en réponse à l'exécution du nub de code d'amorçage, et
réattribuer des broches de sélection de puce non utilisées pour porter des mots de sélection de puce codée après la mise à jour du mode de fonctionnement.

20. Procédé selon la revendication 16, dans lequel
la génération du mot de sélection de puce codée comprend la génération du mot de sélection de puce codée de sorte que le mot de sélection de puce codée comprend exactement un bit de sélection de puce actif, et
la génération du mot de sélection de puce non codée comprend la génération du mot de sélection de puce non codée de sorte que le mot de sélection de puce non codée comprend exactement un bit de sélection de puce actif.

21. Procédé selon la revendication 16, dans lequel
la génération du mot de sélection de puce codée comprend la génération du mot de sélection de puce codée de sorte que le mot de sélection de puce codée comprend exactement un bit de sélection de puce actif qui correspond à une ligne de sélection de puce prédéterminée utilisée pour sélectionner le dispositif de mémoire avec le nub de code d'amorçage, et
la génération du mot de puce non codée comprend la génération du mot de sélection de puce non codée de sorte que le mot de sélection de puce non codée comprend exactement un bit de sélection de puce actif qui correspond à la ligne de sélection de puce prédéterminée.

22. Procédé selon la revendication 16, dans lequel
la génération du mot de sélection de puce codée comprend la génération du mot de sélection de puce codée de sorte qu'un bit d'ordre inférieur du mot de sélection de puce codée est le seul bit actif du mot de sélection de puce codée, et
la génération du mot de sélection de puce non codée comprend la génération du mot de sélection de puce non codée de sorte qu'un bit d'ordre inférieur du mot de sélection de puce non codée est le seul bit actif du mot de sélection de puce non codée.

23. Support lisible par machine comprenant une pluralité d'instructions qui, en réponse à leur exécution, entraînent, dans un appareil
en réponse à une mise sous tension du système ou une réinitialisation du système
la génération, en réponse à une adresse d'un nub de code d'amorçage et un mode de sélection de puce codée, d'un mot de sélection de puce codée qui sélectionne un dispositif de mémoire avec le nub de code d'amorçage, et
la génération, en réponse à l'adresse d'un nub de code d'amorçage et un mode de sélection de puce non codée, d'un mot de sélection de puce non codée qui comprend le mot de sélection de puce codée du nub de code d'amorçage pour sélectionner le même dispositif de mémoire, peu importe si le mode de fonctionnement est en mode de sélection de puce non codée ou en mode de sélection de puce codée.

24. Support lisible par machine selon la revendication 23, dans lequel la pluralité d'instructions entraîne en outre dans l'appareil
la génération du mot de sélection de puce codée de sorte que le mot de sélection de puce codée comprend exactement un bit de sélection de puce actif, et
la génération du mot de sélection de puce non codée de sorte que le mot de sélection de puce non codée comprend exactement un bit de sélection de puce actif.

25. Support lisible par machine selon la revendication 23, dans lequel la pluralité d'instructions entraîne en outre dans l'appareil
la génération du mot de sélection de puce codée de sorte que le mot de sélection de puce codée comprend exactement un bit de sélection de puce actif qui correspond à une ligne de sélection de puce prédéterminée utilisée pour sélectionner le dispositif de mémoire avec le nub de code d'amorçage, et
la génération du mot de sélection de puce non codée de sorte que le mot de sélection de puce non codée comprend exactement un bit de sélection de puce actif qui correspond à la ligne de sélection de puce prédéterminée.

26. Support lisible par machine selon la revendication 23, dans lequel la pluralité d'instructions entraîne en outre dans l'appareil
la génération du mot de sélection de puce codée de sorte qu'un bit d'ordre inférieur du mot de sélection de puce codée est le seul bit actif du mot de sélection de puce codée, et
la génération du mot de sélection de puce non codée de sorte qu'un bit d'ordre inférieur du mot de sélection de puce non codée est le seul bit actif du mot de sélection de puce non codée.

27. Support lisible par machine selon la revendication 23, dans lequel la pluralité d'instructions entraîne en outre dans l'appareil
la mise à jour d'un mode de fonctionnement en l'un du mode de sélection de puce codée et du mode de sélection de puce non codée.

28. Support lisible par machine selon la revendication 23, dans lequel la pluralité d'instructions entraîne en outre dans l'appareil
l'exécution du nub de code d'amorçage, et
la mise à jour d'un mode de fonctionnement en l'un du mode de sélection de puce codée et du mode de sélection de puce non codée en réponse à l'exécution du nub de code d'amorçage.

29. Support lisible par machine selon la revendication 23, dans lequel la pluralité d'instructions entraîne en outre dans l'appareil l'exécution du nub de code d'amorçage,
la mise à jour d'un mode de fonctionnement en le mode de sélection de puce codée en réponse à l'exécution du nub de code d'amorçage, et
la réattribution de broches de sélection de puce non utilisées pour porter des mots de sélection de puce codée après la mise à jour du mode de fonctionnement.
